**Europäisches Patentamt**

**European Patent Office**

**Office européen des brevets**

(19)

(11) Veröffentlichungsnummer: **0 164 093**
A2

# (12) EUROPÄISCHE PATENTANMELDUNG

(21) Anmeldenummer: 85106849.4

(22) Anmeldetag: 03.06.85

(51) Int. Cl.⁴: **H 01 L 33/00, H 01 S 3/19**

(30) Priorität: 07.06.84 DE 3421215

(43) Veröffentlichungstag der Anmeldung: 11.12.85
Patentblatt 85/50

(84) Benannte Vertragsstaaten: **DE FR GB NL**

(71) Anmelder: **Siemens Aktiengesellschaft, Berlin und München Wittelsbacherplatz 2, D-8000 München 2 (DE)**
Anmelder: **AEG - TELEFUNKEN AKTIENGESELLSCHAFT, Theodor-Stern-Kai 1, D-6000 Frankfurt 70 (DE)**
Anmelder: **TELEFUNKEN electronic GmbH, Theresienstrasse 2, D-7100 Heilbronn (DE)**

(72) Erfinder: **Kuphal, Eckart, Dr., Webergasse 9, D-6100 Darmstadt (DE)**
Erfinder: **Burkhard, Herbert, Dr., Troyesstrasse 46, D-6100 Darmstadt (DE)**

(74) Vertreter: **Mehl, Ernst, Dipl.-Ing. et al, Postfach 22 01 76, D-8000 München 22 (DE)**

(54) **Verfahren zur Erzeugung von InGaAsP und InGaAs-Doppelheterostrukturlasern und -LED's mittels Flussigphasenepitaxie für einen Wellenlängenbereich von alpha = 1,2 um bis 1,7 um.**

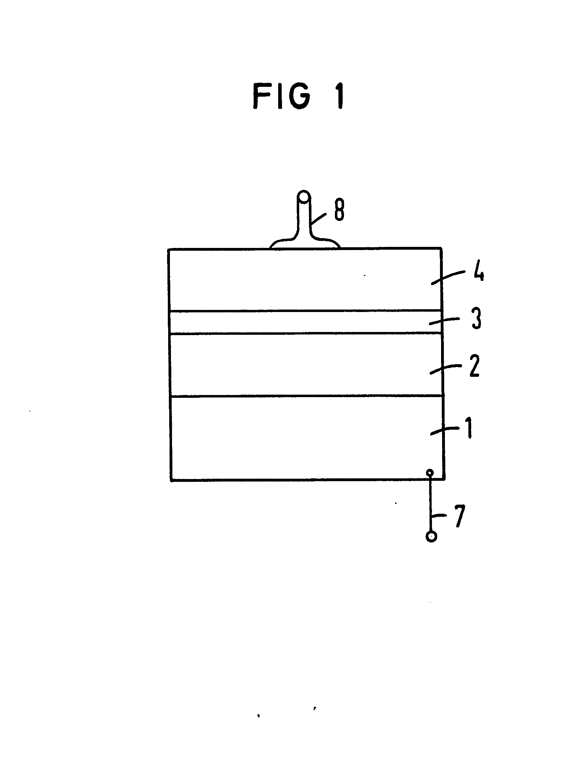

(57) Die Erfindung betrifft ein Verfahren zur Herstellung von Doppelheterostruktur-InGaAsP/InP- bzw. InGaAs/InP-Lasern und -LED's mittels LPE, die bis zu einer Wellenlänge von $\lambda = 1,7$ µm optische Strahlung emittieren. Durch das Wachsen der InP-Deckschicht aus einer Sn-In-P-Lösung wird das Anlösen der aktiven Schicht bei Gap-Wellenlängen $\lambda_g \geq 1,5$ µm vermieden und somit keine Anti-Meltback-Schicht benötigt. Durch einen inversen Aufbau der Schichtstruktur bezüglich der Dotierung basierend auf einem p-InP-Substrat wird erreicht, dass die zwangsläufig stark n-dotierte InP-Deckschicht den passenden Leitungstyp hat. Ein solcher Doppelheterostruktur-Laser bzw. -LED besteht, wie in Fig. 1 ersichtlich, aus nur drei epitaktischen Schichten, wodurch die Technologie ganz entscheidend vereinfacht wird.

EP 0 164 093 A2

1

**Verfahren zur Erzeugung von InGaAsP- und InGaAs-Doppelheterostruktur-Lasern und -LED's mittels Flüssigphasenepitaxie für einen Wellenlängenbereich von $\lambda = 1,2$ μm bis 1,7 μm**

Die Erfindung betrifft ein Verfahren zur Erzeugung von Doppelheterostruktur-Lasern und -LED's für den Wellenlängenbereich von $\lambda = 1,2$ μm bis 1,7 μm mit einer quaternären aktiven Schicht aus InGaAsP bzw. einer ternären aktiven Schicht aus InGaAs mittels Flüssigphasenepitaxie (LPE).

Herkömmliche für den Dauerstrichbetrieb (CW) geeignete InGaAsP/InP-Laser und -LED's als optische Sender für den Wellenlängenbereich von $\lambda = 1,2$ μm bis $\leq 1,5$ μm werden auf einem n-dotierten (100)-orientierten InP-Substrat aufgebaut. Der Schichtaufbau besteht aus einer n-dotierten InP-Pufferschicht, einer n- oder p-leitenden aktiven InGaAsP-Schicht der entsprechenden Gap-Wellenlänge und einer p-dotierten InP-Deckschicht, der in den meisten Fällen noch eine $p^+$-dotierte InGaAs(P)-Kontaktschicht folgt, um den Kontaktwiderstand herabzusetzen. Diese Laser und LED's werden z.Z. bevorzugt mittels Flüssigphasenepitaxie erzeugt.

Die in der optischen Nachrichtentechnik verwendeten Glasfasern haben allerdings ihr Dämpfungsminimum im Wellenlängenbereich von $\lambda = 1,5$ μm bis 1,7 μm. Um Laser und LED's zu erzeugen, die in diesem wichtigen Wellenlängenbereich emittieren, ist es erforderlich, die Gap-Wellenlänge $\lambda_g$ der aktiven InGaAsP-Schicht entsprechend zu

Bts 1 Kow / 9.4.1985

0164093

erhöhen. Die höchste Gap-Wellenlänge im System InGaAsP wird im Grenzfall $In_{0,53}$ $Ga_{0,47}$ As mit $\lambda_g$ = 1,65 µm erreicht. Die Emissionswellenlänge des ternären Lasers oder der ternären LED liegt je nach Dotierung, Injektionsstrom und Temperatur im Bereich $\lambda$ = 1,65 µm bis 1,70 µm. Beim herkömmlichen Schichtenaufbau mittels LPE tritt jedoch bei $\lambda_g \geq$ 1,5 µm folgende Schwierigkeit auf: Die aktive InGaAs(P)-Schicht wird von der nachfolgenden In-P-Lösung, die zum Aufwachsen der InP-Schicht dient, angelöst.

Um diesen Anlöseeffekt zu vermeiden, wird, wie bei Y. Noguchi, K. Takahei, Y. Suzuki und H. Nagai im Japanese Journal of Appl. Phys., Vol. 19, No. 12, Dez. 1982, Seiten L 759 bis L 762 beschrieben, zwischen der aktiven Schicht und der Deckschicht eine quaternäre Anti-Meltback-Schicht mit einer Gap-Wellenlänge kleiner als der der aktiven Schicht gewachsen. Diese Anti-Meltback-Schicht verringert jedoch den Confinement-Faktor des Wellenleiters und muß daher sehr dünn (ca. 0,1 µm) gewählt werden. Diese zusätzliche sehr dünne Schicht macht den LPE-Prozeß komplizierter und daher weniger reproduzierbar.

S. H. Groves und M. C. Plonko (Appl. Phys. Letters, Vol. 38, No. 12, Juni 1981, Seiten 1003 bis 1004) haben gezeigt, daß anlösungsfreies Wachstum von InP auf (100)-orientiertem $In_{0,53}Ga_{0,47}As$ (und damit auch auf InGaAsP) aus einer Sn-In-P-Lösung möglich ist. Die so erzeugte InP-Schicht ist jedoch stark n-dotiert. Sie ist somit nicht als Deckschicht für die bekannten auf n-InP-Substraten basierenden Laser- und LED-Strukturen geeignet, da hierbei eine p-dotierte InP-Deckschicht erforderlich ist.

Bekannt ist ebenfalls, die Strukturierung der epitaktischen Schichtenfolge in Form einer "Pilz"-Struktur auszuführen, um einen index-geführten Laser mit niedrigem Schwellenstrom und hoher optischer Ausgangsleistung zu erzeugen, wie von H. Burkhard und E. Kuphal im Japanese Journal of Appl. Phys., Vol. 22, No. 11, Nov. 1983, Seiten L 721 bis L 723 beschrieben ist. Die "Pilz"-Struktur-Laser haben elektrische und optische Eigenschaften, die den üblicherweise erzeugten "vergrabenen Heterostruktur-Lasern" (BH-Lasern) äquivalent sind, haben aber den Vorteil einer sehr viel einfacheren Technologie, da nur ein Epitaxie-Prozeß im Gegensatz zu zwei Epitaxie-Prozessen beim BH-Laser erforderlich ist.

Die Aufgabe der Erfindung ist es, einen einheitlichen Aufbau von mittels LPE gewachsenen InGaAsP- und InGaAs-Doppelheterostruktur-Lasern und -LED's anzugeben, welche optische Strahlung in einem Wellenlängenbereich von $\lambda$ = 1,2 µm bis 1,7 µm emittieren und keine Anti-Meltback-Schicht aufweisen.

Diese Aufgabe wird durch die im Hauptanspruch gekennzeichnete Erfindung gelöst.

Vorteilhafte Weiterbildungen der Erfindung sind in den Unteransprüchen gekennzeichnet.

Die Anti-Meltback-Schicht wird erfindungsgemäß dadurch vermieden, daß das auf der aktiven InGaAsP- bzw. InGaAs-Schicht anlösungsfreie Wachstum von InP aus einer Sn-In-P-LKösung kombiniert wird mit einem invertierten, auf einem p-leitenden Substrat basierendem Schichtenaufbau. Somit hat die aus der Sn-In-P-Lösung gewachsene n-dotierte InP-Deckschicht den richtigen Leitungstyp.

Das Anlösen der aktiven Schicht ist beim Wachsen der Deckschicht vernachlässigbar gering, da erstens die Löslichkeit von Ga und As bei gleicher Temperatur in einer Sn-
Lösung etwa halb so groß wie in einer In-Lösung ist.
Zweitens ist bei gleicher Temperatur die Löslichkeit von
InP in einer Sn-Lösung wesentlich größer als in einer In-
Lösung, so daß bei gleicher Wachstumsgeschwindigkeit der
Deckschicht die Wachstumstemperatur der Sn-In-P-Lösung
wesentlich herabgesetzt werden kann. Es entspricht z.B.
bei einer In-P-Lösung die Wachstumstemperatur von ca.
700° C der Wachstumstemperatur einer Sn-In-P-Lösung von
ca. 470° C, was die Löslichkeit von Ga und As nochmals
entscheidend verringert. Drittens wird durch Übersättigung
der Sn-In-P-Lösung eine hohe Wachstumsgeschwindigkeit zu
Beginn des Wachstums der Deckschicht erreicht und damit
die Zeit verkürzt, in der ein Anlösen der aktiven Schicht
möglich ist.

Es entsteht somit der wesentliche Vorteil, daß durch den
erfindungsgemäß invertierten Schichtenaufbau unter Wegfallen der Anti-Meltback-Schicht Laser oder LED's mit nur
drei epitaktisch gewachsenen Schichten erzeugt werden
können, die bis zu einer Wellenlänge von $\lambda$ = 1,7 µm
optische Strahlung emittieren. Damit sind auch für den
Wellenlängenbereich von $\lambda$ = 1,5 µm bis 1,7 µm einfach aufgebaute, sicher reproduzierbare und dadurch sehr preiswert herzustellende Laser und LED's verfügbar.

Ein weiterer Vorteil der Erfindung besteht darin, daß sich
durch die invertierte Schichtenfolge der p-Kontakt mit
seinem großen spezifischen Kontaktwiderstand
($p_c \approx 10^{-4} \Omega cm^2$) auf der großflächigen Substratseite befindet, während der n-Kontakt mit seinem sehr kleinen
spezifischem Kontaktwiderstand ($p_c \approx 10^{-6} \Omega cm^2$) sich auf
der im Vergleich zur Substratseite kleinflächig strukturierten epitaktischen Seite befindet. Der n-Kontaktwiderstand wird zusätzlich dadurch noch herabgesetzt, daß die aus einer Sn-Lösung abgeschiedene InP-Schicht eine sehr hohe Trägerdichte von $\acute{n} = (3....4).10^{19}$ cm$^{-3}$ und einen sehr geringen spezifischen Widerstand von $p \approx 3.10^{-4}$ $\Omega$cm aufweist. Der gesamte ohmsche Widerstand und damit die Verlustleistung des Lasers oder der LED werden somit bei dem Aufbau der Schichtenfolge gemäß der Erfindung sehr gering. Damit erübrigt sich auch eine zusätzliche Einfügung einer Kontaktschicht aus einem Material von kleinerem Bandabstand aus InGaAsP oder InGaAs zwischen der Deckschicht und dem Kontakt zur Verringerung des Kontaktwiderstandes, wie sie üblicherweise nach dem Stand der Technik verwendet wird.

Durch den Aufbau der Schichtstruktur als "Pilz"-Struktur ergeben sich bei der Erfindung außer der Herabsetzung der Epitaxieschritte bei der Herstellung im Vergleich zu der BH-Struktur noch die Vorteile, daß die Unterschneidung des Mesas genau kontrollierbar ist und dadurch die Breite der aktiven Schicht ebenfalls sehr genau reproduzierbar ist. Weiterhin ist vorteilhaft, daß durch die V-förmige Ätzung der Bereiche unterhalb des Mesas nicht nur der Mesa selbst mit einer $SiO_2$-Schicht passiviert ist, sondern das $SiO_2$ auch an den Kanten der aktiven Schicht abgeschieden wird. Durch diese Abscheidung dominiert der laterale Grundmode der optischen Emission bis zu Streifenbreiten der aktiven Schicht von einigen $\mu$m.

Außerdem bilden sich beim Passivieren der unterätzten Oberflächen an den Mesarändern $SiO_2$-Brücken zwischen der Deckschicht und der Pufferschicht, welche den Mesa ohne weitere Maßnahmen ausreichend mechanisch stabilisieren.

Die "Pilz"-Struktur ergibt einen niedrigen Schwellenstrom

0164093

im Dauerstrichbetrieb bei Raumtemperatur und der invertierte Schichtenaufbau einen geringen Bahnwiderstand. Die durch diese beiden Vorteile erzielte geringe Verlustleistung des Lasers erlaubt eine Lötung des Chips mit der Substratseite auf der Wärmesenke (z.B. aus Cu). Dies bedeutet eine erhebliche Vereinfachung der Montage gegenüber der üblicherweise angewandten Lötung mit der epitaktischen Seite auf die Wärmesenke. Trotz der durch die substratseitige Lötung ungünstigeren thermischen Ankopplung wird wegen der geringen Verlustleistung die Temperatur am p-n-Übergang und somit der Schwellenstrom nicht nennenswert erhöht.

Außerdem ist die substratseitige Lötung des Laserchips eine Voraussetzung für eine monolythische Integration des Lasers mit weiteren Bauelementen.

Die Erfindung wird anhand der Zeichnung näher erläutert. Es zeigt Fig. 1 den Aufbau der Schichten eines Lasers oder einer LED nach der Erfindung,

Fig. 2 die Licht-Strom-Kennlinien eines InGaAsP-Lasers,

Fig. 3 das Emissionsspektrum dieses InGaAsP-Lasers,

Fig. 4 die Licht-Strom-Kennlinien sowie die Strom-Spannungs-Kennlinie eines InGaAs-Lasers und

Fig. 5 das Emissionsspektrum dieses InGaAs-Lasers.

Die Schichten des in Fig. 1 gezeigten Doppelheterostruktur-Lasers oder -LED werden in einem temperaturgesteuerten Ofen unter einer $H_2$-Atmosphäre mittels LPE abgeschieden. Auf einem p-dotierten (100)-orientierten InP-Substrat 1 wird zunächst eine p-dotierte InP-Pufferschicht 2 abgeschieden, um einen möglichst ungestörten Übergang zur aktiven
Schicht zu schaffen. Darüber folgt die aktive Schicht 3
aus InGaAsP oder InGaAs mit einer Gap-Wellenlänge.
$\lambda_g \geq 1,5$ µm, z.B. aus $In_{0,53}Ga_{0,47}As$ mit $\lambda'_g = 1,65$ µm und
darüber die $n^+$-InP-Deckschicht 4. Mit 7 und 8 sind vorzusehende Anschlüsse bzw. Elektroden bezeichnet.

Bei der zum Wachsen der InP-Deckschicht 4 bestimmten Sn-
In-P-Lösung führt der hohe Dampfdruck des Phosphors (P),
der ursächlich mit der hohen Löslichkeit von P in Sn zusammenhängt, zu einem Abdampfen von P und so zu einer Erniedrigung der Sättigungstemperatur der Lösung. Durch diesen P-
Verlust wird in der Lösung $x(P) < x(In)$, so daß das
bekannte Phasendiagramm für eine InP-Sn-Lösung, bei der
$x(P) = x(In)$, nicht mehr anwendbar ist. Hierbei bedeutet x
den Atomanteil des entpsrechenden Elementes in der Lösung.
Durch das Bestimmen des Phasendiagramms des Systems
Sn-In-P und durch Messen der Verdampfungsverluste von P
als Funktion der Temperatur läßt sich jedoch die Zusammensetzung und die Sättigungstemperatur der Sn-In-P-Lösung
während des Homogenisierens und während des Wachsens der
InP-Deckschicht genau berechnen.

Die Lösungen, aus denen die einzelnen Schichten gewachsen
werden, befinden sich bei diesem Beispiel in den Kammern
eines horizontalen Mehrkammerschiebetiegel. Alle Kammern
sind mit Graphitdeckeln nach oben verschlossen. Die Strömungsgeschwindigkeit der $H_2$-Atmosphäre beträgt 0,5 cm/s.

In der ersten Kammer des Schiebetiegels ist eine
Zn-dotierte In-P-Lösung, in der zweiten Kammer ist eine
undotierte In-Ga-As-Lösung mit gleichen Anteilen von Ga
und As mit $x(Ga) = x(As) = 1,13$ %, was einer Sättigungstemperatur von $505^\circ$ C im Gleichgewicht mit $In_{0,53}Ga_{0,47}As$
entspricht, die dritte Kammer ist leer, und die vierte Kammer ist mit einer Lösung von 18,5 mg InP pro 1 g Sn gefüllt. Der Ofen wird auf eine Temperatur von 540$^o$ C aufgeheizt, um eine Homogenisierung der Lösungen zu ereichen. Es zeigt sich, daß eine Homogenisierungszeit von nur 30 min, die aus Gründen eines möglichst geringen P-Verdampfungsverlustes aus der Sn-In-P-Lösung so kurz gewählt wird, dennoch ausreichend lang ist, um eine sehr gleichmäßige Dicke aller drei epitaktischen Schichten zu gewährleisten.

Nach dieser Vorheizzeit und der Abkühlung des Ofens auf 520$^o$ C wird das Substrat unter die erste Kammer gebracht und die Pufferschicht 2, beginnend bei einer Temperatur von 520$^o$ C, bis zu einer Temperatur von 501$^o$ C gewachsen. Durch Verschieben des Substrats unter die zweite Kammer wird die aktive Schicht 3 bei einer konstanten Temperatur von 501$^o$ C gewachsen. Um eine InGaAsP-Schicht zu erzielen, ist es nicht erforderlich, der In-Ga-As-Schmelze P zuzuführen, da durch den verdampfenden P aus der vierten Kammer eine Sättigung der In-Ga-As-Schmelze mit P erfolgt.

Im nächsten Schritt wird das Substrat unter die Leerkammer gebracht und die Ofentemperatur auf 473,0$^o$ C abgesenkt. Nach dem Verschieben des Substrats unter die vierte Kammer mit der Sn-In-P-Lösung beginnt das Wachstum der InP-Deckschicht 4, während die Abkühlrate des Ofens 10$^o$ C/h beträgt. Es wird innerhalb von 2,0 min eine Schichtdicke von 1,5 µm erzielt, wobei nach der ersten Sekunde bereits eine Schichtdicke von 0,13 µm gewachsen ist. Die Sättigungstemperaturen dieser Lösung sind vor dem Vorheizen 478,8$^o$ C, nach dem Vorheizen 478,0$^o$ C und nach dem Epitaxieprozeß 476,5$^o$ C.

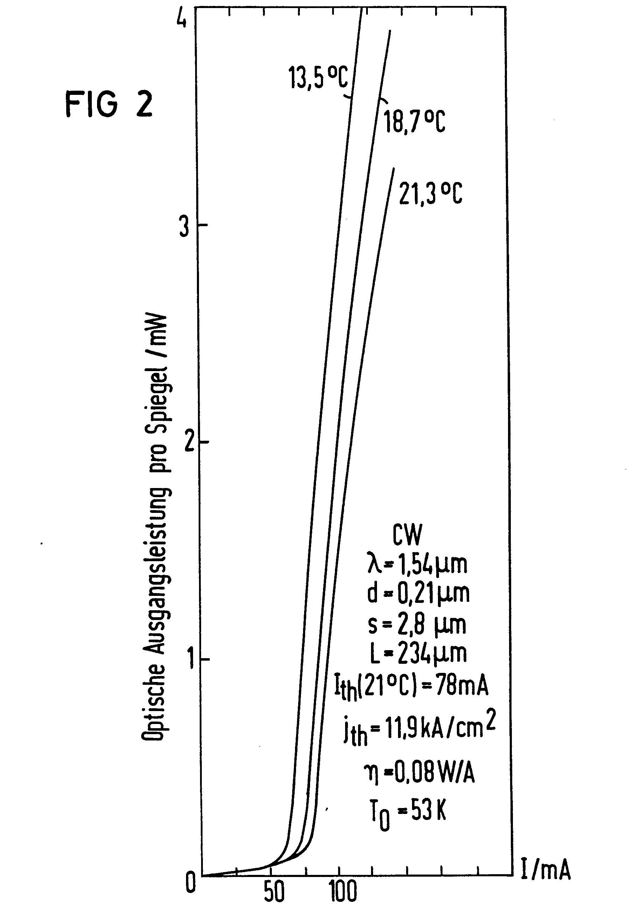

Die Fig. 2 zeigt Licht-Strom-Kennlinien bei verschiedenen

0164093

Temperaturen eines so erzeugten InGaAsP/InP-Lasers, bei dem die "Pilz"-Struktur angewendet wurde und der bei einer Wellenlänge von $\lambda$ = 1,54 µm emittiert.

Der Schwellenstrom im Dauerstrichbetrieb bei Zimmertemperatur beträgt in diesem Beispiel $I_{th}$ = 78 mA, die Schwellenstromdichte $j_{th}$ = 11,9 kA/cm$^2$, die Steilheit n = 0,08 W/A pro Spiegel und die Temperaturempfindlichkeit $T_o$ = 53 K. Es können Lichtleistungen pro Spiegel bis zu 4 mW im Dauerstrichbetrieb unschwer erzielt werden. Die Abmessungen des aktiven Volumens d, s und L sind ebenfalls in Fig. 2 angegeben.

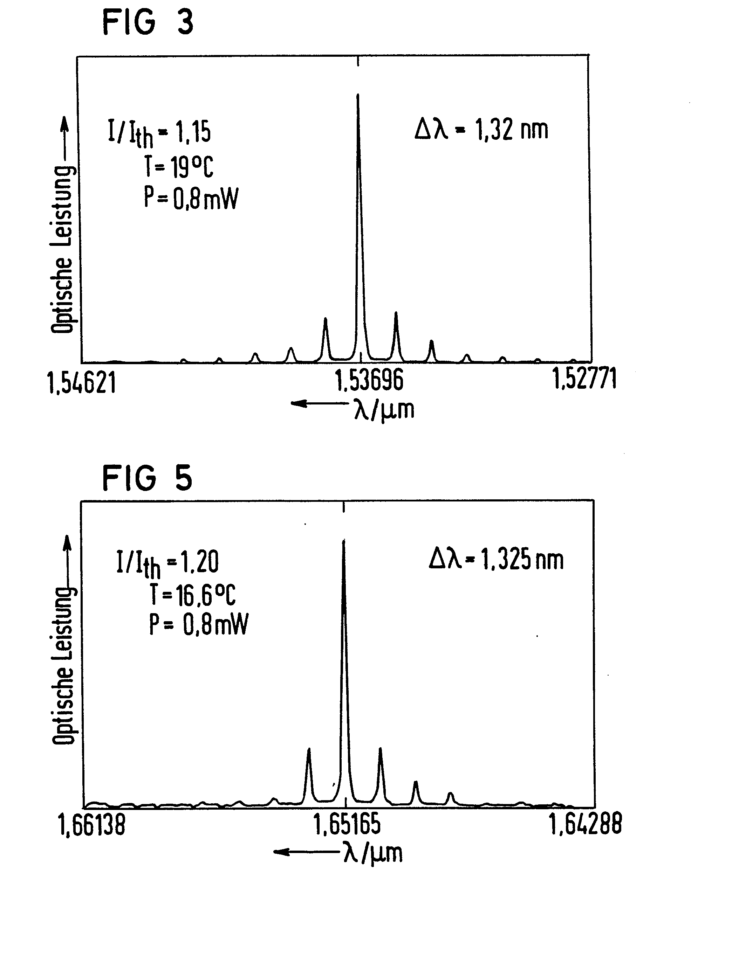

Die Fig. 3 zeigt das Emissionsspektrum dieses InGaAsP/InP-Lasers bei einem Anregungsstrom von 15 % über dem Schwellenstrom und einer Ausgangsleistung von P = 0,8 mW pro Spiegel. Der Laser schwingt nahe bei = 1,54 µm im lateralen Grundmode in nur wenigen axialen Moden. Der Modenwellenlängenabstand beträgt $\Delta\lambda$ = 1,32 nm.

Um einen InGaAs/InP-Laser oder eine entsprechende LED herzustellen, genügt es im Prinzip, die Kammer des Schiebetiegels mit der Sn-In-P-Lösung bzw. mit der In-Ga-As-Lösung gasdicht zu verschließen. Eine solche Abdichtung ist jedoch schwer zu realisieren, so daß es zweckmäßiger ist, den Epitaxieprozeß in zwei Schritte aufzuteilen.

Im ersten Schritt werden die Pufferschicht 2 und die aktive Schicht 3 gewachsen, wobei sich keine Sn-In-P-Lösung im Ofen befindet. Aus diesem Grund kann die Wachstumstemperaturbeider Schichten auf 600$^o$ C bis 650$^o$ C erhöht werden, da das Abdampfen von P aus der verschlossenen In-P-Lösung vernachlässigbar ist und somit keine Kontamination der In-Ga-As-Lösung mit P stattfinden kann. Nach dem Abkühlen des Ofens und dem Austausch der In-P-Lösung und der In-Ga-As-Lösung gegen die Sn-In-P-Lösung wird mit dem gleichen Temperaturablauf wie bei der Herstellung des InGaAsP/InP-Lasers die Deckschicht 4 gewachsen.

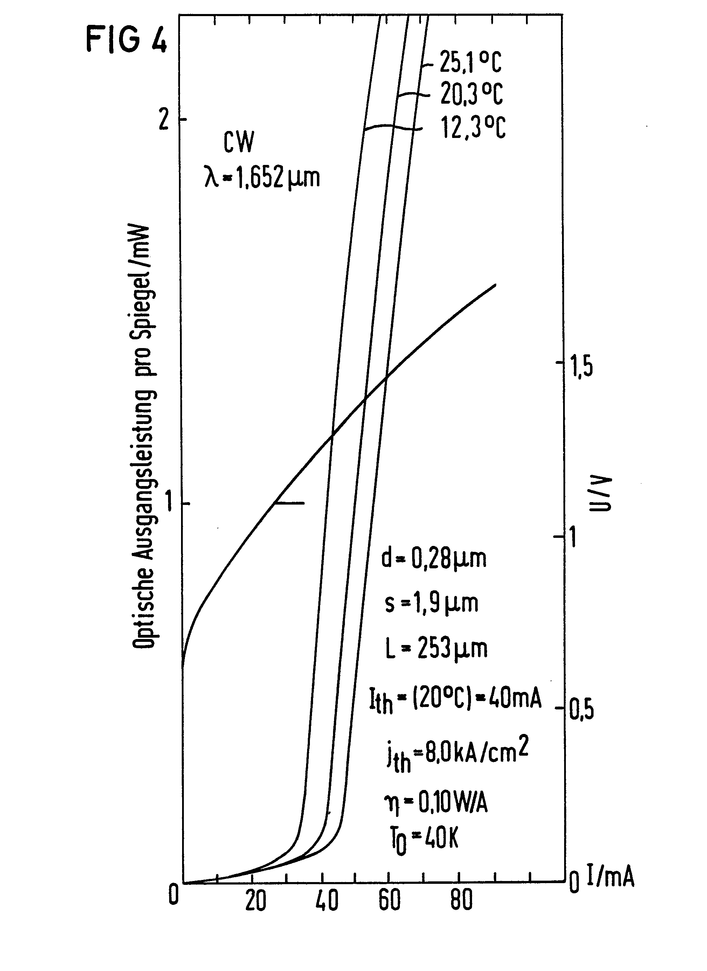

Fig. 4 zeigt Licht-Strom-Kennlinien eines so erzeugten InGaAs/InP-Lasers, bei dem ebenfalls die "Pilz"-Struktur angewendet wurde und der bei $\lambda = 1,65$ µm emittiert. Der Schwellenstrom im Dauerstrichbetrieb bei Zimmertemperatur beträgt bei diesem Exemplar $I_{th} = 40$ mA entsprechend einer Schwellenstromdichte $j_{th} = 8,0$ kA/cm$^2$.Die Steilheit der Kennlinie beträgt n = 0,10 W/A, und die Temperaturempfindlichkeit ist $T_o = 40$ K.

Da die Dicke der aktiven Schicht bei diesem Exemplar mit d = 0,28 µm noch zu groß ist, kann bei geringerem d noch eine Reduktion von $I_{th}$ und $j_{th}$ erwartet werden. Trotzdem sind diese ermittelten Werte von $I_{th}$ und $j_{th}$ bereits gleich denen von ternären Lasern mit Anti-Meltback-Schicht und BH-Struktur nach dem heutigen Stand der Technik. Es ist daraus ersichtlich, daß die hier angewandte Unterbrechung der Epitaxie an der Grenzfläche von aktiver Schicht 3 zu Deckschicht 4 und die Verwendung der aus einer Sn-In-P-Lösung abgeschiedenen extrem stark Sn-dotierten Deckschicht 4 keine nennenswerte Erhöhung der Schwellenstromdichte verursacht.

Ferner zeigt die Fig. 4 die Strom-Spannungs-Kennlinie dieses Lasers, die einen Knick bei ca. 0,75 V entsprechend dem Bandabstand von InGaAs ($E_g = 0,75$ eV) und einen sehr niedrigen ohmschen Widerstand von 0,9 $\Omega$ aufweist. Dieser Wert ist wesentlich niedriger als der eines ternären Lasers auf n-Substrat mit BH-Struktur ($\sim 7\Omega$), für den

insgesamt 6 epitaktische Schichten erforderlich sind, der aber im übrigen vergleichbare Werte des Schwellenstroms und der Steilheit aufweist.

Die Fig. 5 zeigt das Emissionsspektrum des InGaAs/InP-Lasers von Fig. 4 bei einem Anregungsstrom von 20 % über dem Schwellenstrom und einer Ausgangsleistung von P = 0,8 mW pro Spiegel. Der Laser schwingt nahe bei $\lambda$ = 1,65 µm im lateralen Grundmode und ebenso wie der InGaAsP/InP-Laser in nur wenigen axialen Moden. Der Modenwellenlängen-abstand beträgt $\Delta\lambda$ = 1,325 nm.

Eine Untersuchung beider Lasertypen im Rasterelektronenmikroskop ergab, daß die Deckschicht praktisch anlösungsfrei auf der aktiven Schicht aufgewachsen ist. Die Rauhtiefe dieser InGaAsP/InP- bzw. InGaAs/InP-Grenzfläche wurde zu < 20 nm ermittelt. Diese Rauhtiefe ist somit nur $\leq$ 10 % der optimalen Dicke der aktiven Schicht von $\sim$ 0,2 µm.

11 Patentansprüche
 5 Figuren

Patentansprüche

1. Verfahren zur Erzeugung von Doppelheterostruktur-Lasern und -LED's für den Wellenlängenbereich von $\lambda = 1,2$ µm bis 1,7 µm mit einer quaternären aktiven Schicht aus InGaAsP bzw. einer ternären aktiven Schicht aus InGaAs mittels Flüssigphasenepitaxie (LPE),
dadurch g e k e n n z e i c h n e t ,
daß die Laser- oder LED-Struktur auf einem (100)-orientierten p-InP-Substrat ohne eine Anti-Meltback-Schicht aufgebaut ist und aus mindestens drei im Vergleich zu bekannten Lasern oder LED's invertiert nacheinander epitaktisch und gitterangepaßt aufgewachsenen Schichten, nämlich einer p-InP-Pufferschicht, einer aktiven InGaAsP- oder InGaAs-Schicht und einer $n^+$-InP-Deckschicht aufgebaut ist und daß die $n^+$-InP-Deckschicht aus einer Sn-In-P-Lösung abgeschieden wird.

2. Verfahren nach Anspruch 1, dadurch g e k e n n-z e i c h n e t , daß der Verdampfungsverlust des P aus der Sn-In-P-Lösung während der Aufheizphase und während des Epitaxieprozesses bei der Herstellung der Sn-In-P-Lösung und bei der Ermittlung der Sättigungstemperatur dieser Lösung berücksichtigt wird.

3. Verfahren nach Anspruch 2, dadurch g e k e n n-z e i c h n e t , daß die Sn-In-P-Lösung mit InP übersättigt ist.

4. Verfahren nach Anspruch 1, dadurch g e k e n n-z e i c h n e t , daß das Aufwachsen der drei Schichten aus einem Mehrkammertiegel bei möglichst niedrigen Temperaturen nacheinander in einem Epitaxieprozeß erfolgt.

0164093

5. Verfahren nach Anspruch 4, dadurch   g e k e n n -
z e i c h n e t   , daß die Pufferschicht in einem Temperaturintervall zwischen ca. 520$^o$ C und ca. 501$^o$ C, die
aktive InGaAsP- oder InGaAs-Schicht bei einer Temperatur
um 501$^o$ C und nach einer Abkühlung, während der sich das
Substrat unter keiner der Lösungen befindet, die
Deckschicht bei einer Temperatur um 473$^o$ C aufgewachsen
werden.

6. Verfahren nach Anspruch 5, dadurch   g e k e n n -
z e i c h n e t   , daß bei der Herstellung einer
Schichtstruktur mit einer aktiven InGaAs-Schicht alle die
Lösungen enthaltenden Kammern gasdicht verschlossen sind.

7. Verfahren nach Anspruch 1, dadurch   g e k e n n -
z e i c h n e t   , daß sich in einem ersten Epitaxieprozeß nur die p-dotierte In-P-Lösung und die In-Ga-As-
Lösung in einem Mehrkammertiegel befinden und die p-InP-
Pufferschicht und die aktive InGaAs-Schicht nacheinander
aufgewachsen werden und daß nach dem Austausch dieser
beiden Lösungen gegen eine Sn-In-P-Lösung in einem zweiten
Epitaxieprozeß die n$^+$-InP-Deckschicht aufgewachsen wird.

8. Verfahren nach Anspruch 7, dadurch   g e k e n n -
z e i c h n e t   , daß der erste Epitaxieprozeß im
Temperaturbereich zwischen 500$^o$ C und 650$^o$ C stattfindet
und der zweite Epitaxieprozeß bei etwa 473$^o$ C stattfindet.

9. Verfahren nach Anspruch 1, dadurch   g e k e n n -
z e i c h n e t   , daß der Laser oder die LED in einem
mehrstufigem Ätzverfahren zu einer an sich bekannten
"Pilz"-Struktur geformt wird.

0164093

10. Verfahren nach Anspruch 9, dadurch    g e k e n n-
z e i c h n e t    , daß die unterätzten Oberflächen der
Pilzstruktur mit $SiO_2$ passiviert werden.

11. Verfahren nach Anspruch 10, dadurch    g e k e n n-
z e i c h n e t    , daß der Laser oder die LED mit der
p-InP-Substratseite auf eine Wärmesenke aufgebracht wird.

FIG 1

FIG 2

Optische Ausgangsleistung pro Spiegel / mW

13,5 °C

18,7 °C

21,3 °C

CW
$\lambda = 1,54\,\mu m$
$d = 0,21\,\mu m$
$s = 2,8\,\mu m$
$L = 234\,\mu m$
$I_{th}(21°C) = 78\,mA$
$j_{th} = 11,9\,kA/cm^2$
$\eta = 0,08\,W/A$
$T_0 = 53\,K$

I/mA

0164093

## FIG 3

$I/I_{th} = 1{,}15$
$T = 19°C$
$P = 0{,}8\,mW$

$\Delta\lambda = 1{,}32\ nm$

Optische Leistung

1,54621     1,53696     1,52771

$\longleftarrow \lambda/\mu m$

## FIG 5

$I/I_{th} = 1{,}20$
$T = 16{,}6°C$
$P = 0{,}8\,mW$

$\Delta\lambda = 1{,}325\ nm$

Optische Leistung

1,66138     1,65165     1,64288

$\longleftarrow \lambda/\mu m$

FIG 4

4/4

0164093

CW
$\lambda = 1,652\,\mu m$

Optische Ausgangsleistung pro Spiegel /mW

25,1 °C
20,3 °C
12,3 °C

$d = 0,28\,\mu m$

$s = 1,9\,\mu m$

$L = 253\,\mu m$

$I_{th} = (20°C) = 40\,mA$

$j_{th} = 8,0\,kA/cm^2$

$\eta = 0,10\,W/A$

$T_0 = 40\,K$

U/V